# EUROPÄISCHE PATENTSCHRIFT

(11) **EP 0 826 970 B1**
(45) Veröffentlichungstag und Bekanntmachung des Hinweises auf die Patenterteilung: **10.03.2004**
(21) Anmeldenummer: 97114369.8
(22) Anmeldetag: 20.08.1997
(51) Int. Cl.: G01R 15/24

(54) **Spannungswandler**
Voltage transducer
Capteur de tension

(30) Priorität: 26.08.1996 DE 19634251
(43) Veröffentlichungstag der Anmeldung: 04.03.1998
(73) Patentinhaber: ABB PATENT GmbH, 68526 Ladenburg (DE)
(72) Erfinder: Yakymyshyyn, Christopher P., Bozeman, Montana 59717 (US); Brubaker, Michael A., Raleigh, NC 27615 (US); Mendez, Alexis, Raleigh, NC 27612 (US); Ebbinghaus, Dirk, 44536 Lünen (DE); Schwarz, Michael, 44536 Lünen (DE)
(74) Vertreter: Miller, Toivo

(56) Entgegenhaltungen:
- EP-A- 0 682 261
- US-A- 3 714 831
- US-A- 3 938 039
- PATENT ABSTRACTS OF JAPAN vol. 7, no. 202 (P-221) [1347], 7. September 1983 & JP 58 099762 A (MITSUBISHI DENKI), 14. Juni 1983
- ANAGNI F ET AL: "OPTICAL SENSORS FOR ELECTRIC SUBSTATIONS: A VOLTAGE PRESENCE DETECTOR USING A LIQUID CRYSTAL CELL" IEEE TRANSACTIONS ON INSTRUMENTATION AND MEASUREMENT, Bd. 43, Nr. 3, 1. Juni 1994, Seiten 475-480, XP000458993

## Beschreibung

Die Erfindung betrifft einen Spannungswandler gemäß dem Oberbegriff des Anspruches 1.

Spannungswandler, bei denen ein den Pockelseffekt aufweisender Kristall verwendet wird, sind beispielsweise aus der DE-B Schwab, Hochspannungstechnik, 2. Auflage, Springer Verlag, Seite 176 ff., insbesondere 177 bis 179, 181 bis 184, bekannt geworden. Im Gegensatz zu sog. konventionellen Spannungswandlern können Spannungswandler, die den Pockelseffekt ausnutzen, hochfrequente Feld- oder Spannungsänderungen messen. Dabei ist eine Potentialtrennung gegeben; es treten keine Ferroresonanzen auf und die Anordnung ist unempfindlich gegen elektromagnetische Störungen.

Ein Spannungswandler, bei dem der Pockelseffekt ausgenutzt wird, ist beispielsweise aus der EP 0 410 234 B1 bekannt geworden. Der Kristall, der hierbei verwendet wird, ist ein Quarzkristall und das von einer Lichtquelle erzeugte, mit einem Polarisator polarisierte Licht durchstrahlt den Quarzkristall in einer Richtung, die senkrecht zu den Feldlinien des elektrischen Feldes verläuft. Ausgangsseitig wird der durch den Kristall beeinflußte Lichtstrahl mittels eines Strahlenteilers in zwei Lichtstrahlen aufgeteilt, die je durch einen Analysator hindurch verlaufen und mittels Lichtleitern einem Empfänger zugeleitet werden.

Spannungswandler, bei denen der Pockelseffekt oder ein ähnlicher Effekt ausgenutzt wird, sind auch aus der US 3 363 174 bekannt geworden. Dort durchstrahlt Licht eine Stange aus einem Kristall, wobei der Lichtstrahl den Kristall in Richtung der Feldlinien bzw. parallel dazu durchstrahlt, und eine Fotozelle vorgesehen ist, die das durch den stangenartigen Kristall modulierte Licht auffängt und weiter verarbeitet. Die Anordnung ist als Freiluftspannungswandler ausgeführt; für SF₆-gasisolierte, metallgekapselte Schaltanlagen ist diese Anordnung nicht geeignet.

Ein Spannungsmeßgerät der eingangs genannten Art ist auch aus der EP 0 083 196 B1 bekannt geworden. Dort werden neben Kristallen aus KDP, ADP, LiNbO₃ und LiTaO₃ auch Kristalle, die als BGO bezeichnet werden (und eine Zusammensetzung aufweisen mit Bi₁₂GeO₂₀,) verwendet. Der Kristall besitzt dabei zwei Elektroden, die transparent sind; der Lichtstrahl verläuft in Richtung des elektrischen Feldes. Der Lichtstrahl wird dabei zunächst durch einen Polarisator, eine Lamda-¼-Platte, den Kristall und durch einen Analysator geleitet und das mit dem Analysator beeinflußte Licht weiter verarbeitet. Die Druckschrift beschreibt den Spannungswandler lediglich im Prinzip.

Die Literaturstelle Firmenzeitschrift der Firma SUMITOMO ELECTRIC beschreibt ein Meßgerät, bei dem der Kristall in einem Kern angeordnet ist, der um einen elektrischen Leiter herumgelegt wird. Das Kristallmaterial ist BSO.

Ein Spannungssensor zum Einsatz in gasisolierten, metallgekapselten Hochspannungsschaltanlagen ist aus der JP 58 099 762 bekannt.

Aus der EP 0 682 261 A1 sind ein Verfahren und eine Vorrichtung zur Spannungsmessung nach dem Pockelseffekt bekannt. Dort wird ein zylindrischer Kristall in Längsrichtung von polarisiertem Licht durchstrahlt, der Lichtstrahl an der Stirnseite des Kristalls reflektiert und beim Austritt aus der anderen Stirnseite des Kristalls in zwei Teilstrahlen geteilt, von denen einer durch eine Lamda-¼-Verzögerungsplatte geleitet wird. Die beiden Lichtstrahlen werden von je einem Lichtdetektor erfasst und mittels eines Mikroprozessors erfolgt eine Auswertung der erhaltenen Signale.

Aufgabe der Erfindung ist es, einen Spannungswandler der eingangs genannten Art so weiterzubilden, dass er ohne weiteres in einer metallgekapselten, SF₆-gasisolierten Schaltanlage verwendet werden kann.

Diese Aufgabe wird erfindungsgemäß dadurch gelöst, dass an den Enden des Kristalls Mittel zur Feldliniensteuerung vorgesehen sind, so dass die elektrischen Feldlinien im Bereich des Kristalls genau parallel zu den Lichtstrahlen, die den Kristall durchsetzen, verlaufen.

Die Verwendung einer Lamda-¼-Platte ist aus der EP 0 083 196 B1, bekannt; dort allerdings liegt die Lamda-¼-Platte in Lichtstrahlrichtung gesehen, vor dem Kristall.

Der Spannungswandler ist dabei zwischen einem Innenleiter und einem am Gehäuse der Metallkapselung angebrachten Arm fixiert, so daß der Spannungswandler mit einem Ende auf Hochspannungspotential und mit dem anderen Ende auf Erdpotential liegt.

Als Mittel zur Feldliniensteuerung können Abschirmungen an den Enden des Spannungswandlers und darüber hinaus eine transparente, elektrisch leitende Schicht an den Endwänden des Kristalls vorgesehen sein; mit dieser transparenten, elektrisch leitenden Schicht werden die Feldlinien innerhalb des Kristalls parallel zu den Lichtstrahlen ausgerichtet und Feldüberhöhungen vermieden.

Zum Schutz ist der langgestreckte zylindrische Kristall in einem rohrförmigen Gehäuse untergebracht, welches in eine Vertiefung der Abschirmungen eingreift und darin mittels wenigstens eines am Außenumfang des Rohres angeordneten weichelastischen Ringes elastisch gedämpft ist.

Der Kristall selbst ist an seinem hochspannungsseitigen Ende zusammen mit dem Umlenkprisma in eine Vertiefung einer Haltearmatur eingesetzt, die am Boden der hochspannungsseitigen Abschirmung unter Zwischenfügung einer elastischen Auflage eingesetzt ist; das Rohr umfaßt teilweise die Haltearmatur an deren Außenumfang. Mit der hochspannungsseitigen Abschirmung ist der Spannungswandler an einem Innenleiter befestigt.

Gemäß einer weiteren vorteilhaften Ausführungsform ist das niederspannungsseitige oder erdpotentialseitige Ende des Kristalls in einer weiteren, rohrartigen Haltearmatur gehalten, die ebenfalls von außen teilweise vom Rohr umfaßt ist. Das Rohr mit der Haltearmatur ist in der niederspannungsseitigen Abschirmung unter Zwischenfügung eines oder mehrerer elastischer Ringe gelagert; mittels der Abschirmung ist das niederspannungsseitige Ende des Spannungswandlers an dem Haltearm der Metallkapselung fixiert.

Die weitere Haltearmatur umfaßt und schützt auch die optischen Teile wie Lichteinkoppler, Strahlenteiler, Lichtauskoppler, Lamda-¼-Platte und Polarisatoren und Analysatoren; sie ist dann von einer Kappe abgedeckt, deren Zylinderwand die weitere Haltearmatur außen umfaßt. Die Abdeckkappe besitzt gemäß einer weiteren Ausgestaltung der Erfindung ein Filter, das die Verunreinigung des Isoliergases und Feuchtigkeit vom Innenraum des Spannungswandlers fernhält.

Weitere vorteilhafte Ausgestaltungen der Erfindung sind den weiteren Unteransprüchen zu entnehmen.

Anhand der Zeichnung, in der ein Ausführungsbeispiel der Erfindung dargestellt ist, sollen die Erfindung sowie weitere vorteilhafte Ausgestaltungen und Verbesserungen der Erfindung näher erläutert und beschrieben werden.

Es zeigen:
- Fig. 1: eine Schnittansicht durch einen Spannungswandler in einer Schaltanlage,
- Fig. 2: eine vergrößerte Darstellung des Spannungswandlers, und
- Fig. 3: eine perspektivische Darstellung, in Explosionsdarstellung, des Kristalls mit optischen Elementen.

An einem Flansch 10 einer gasisolierten, metallgekapselten Hochspannungsanlage ist ein Halter oder Isolatorring 11 für einen Isolator 12 mit einer Schraubenverbindung 13 befestigt, wobei der Querschnitt des Halters 11 eine U-Form besitzt, deren offene Seite nach innen gerichtet ist und deren Schenkel 15, 16 den Isolator 12 festhalten. Der Isolator 12 kann dabei ein Schottisolator oder lediglich ein Isolator sein. Die Schaltanlage besitzt Innenleiter 17, 18, die mit Durchführungen 19 (nur eine Durchführung ist sichtbar) in dem Isolator 12 elektrisch leitend auf einer Seite des Isolators 12 (in der Zeichnung unten) verbunden sind.

Auf der anderen, oberen Seite des Isolators bzw. der Durchführung 19 ist ein Spannungswandler 20 für jede Phase befestigt, dessen anderes Ende an einem Tragarm 21 bzw. 22 einer topfförmigen Haube 23 fixiert ist, die mittels eines Flansches 24 mit dem Halter 11 verbunden ist. Die topfförmige Haube 23 ist an der dem Flansch 24 entgegengesetzten Seite mit einem Montageloch 25 versehen, welches unter Zwischenfügung einer Dichtung 26 mit einem Deckel 27 mittels Schraubenverbindungen 28 verschlossen ist.

Auf der Durchführung 19 ist eine topfförmige Abschirmung 29 mittels einer Schraubenverbindung 30 befestigt, wobei in die Abschirmung 29 das hochspannungsseitige Ende des Spannungswandlers 20 eingreift und darin radial mittels gummielastischen Schaumstoffringen 31 und axial mittels eines Auflageringes 32, der ebenfalls aus gummielastischem Schaumstoffmaterial besteht, gelagert ist. Die Ringe 31, 32 dienen dabei der Dämpfung und dem Schutz gegen Schwingungsbewegungen.

An der dem Isolator 12 zugewandten Seite des Haltearmes 21 ist ebenfalls eine Abschirmung 33 mittels Schraubenverbindungen 34 befestigt, in die das niederspannungsseitige Ende des Spannungswandlers 20 eingreift und darin ebenfalls radial mit gummielastischen Schaumstoffringen 35 gelagert ist. Der Spannungswandler 20 durchdringt den Tragarm 21 und ist auf dessen Oberseite mittels einer mit den Schraubenverbindungen 34 an der oberen Seite des Tragarmes 21 fixierten Abdeckkappe 36 abgedeckt. Innerhalb des Spannungswandlers 20 befindet sich ein Filter 37, mit dem verhindert wird, daß ins Innere des Spannungswandlers 20 Zersetzungsstoffe des lsoliergases und Feuchtigkeit eingdringen können.

Aus dem Spannungswandler sind Lichtleiter 38 herausgeführt, die durch Öffnungen 39 bzw. 40 mit geeigneten Durchführungen herausgeführt, siehe korrespondierende Patentanmeldung P ..... (Mp.-Nr. 96/644).

Die Abdeckhaube 23 besitzt noch einen Stutzen 41, der für die Erfindung keine Bedeutung besitzt.

Die Potentialübertragung auf den Wandler erfolgt auf der Hochspannungsseite mit einer Kontaktfeder 29a, die in einer Innenrille 29b der Abschirmung 29 sitzt und die Abschirmung 29 mit der Außenfläche einer Haltearmatur 49 (siehe weiter unten) kontaktiert, und auf der Erdseite mit einem Kabel 63a, welches auf der Abdeckkappe 36 mit einer Schraubenverbindung 34 befestigt ist, siehe auch weiter unten.

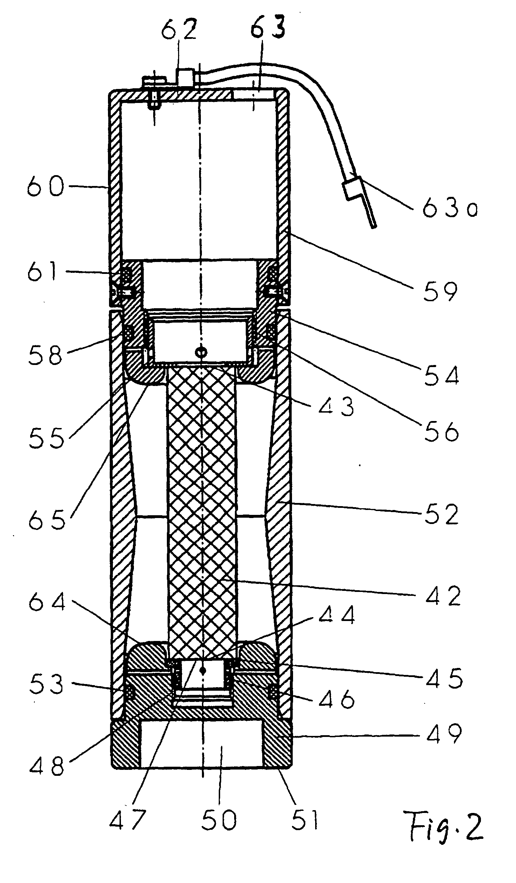

Es sei nun Bezug genommen auf die Fig. 2.

Der Spannungswandler 20 besitzt als Hauptteil einen stabförmigen Kristall 42, der transparent ist und aus einem Material besteht, welches den Pockelseffekt aufweist. Als solches Material kann beispielsweise BGO dienen. Die Endflächen 43 und 44 sind exakt parallel zueinander und mit einem elektrisch leitfähigen, ebenfalls für das polarisierte Licht durchlässigen Material beschichtet, damit im Bereich des Spannungswandlers die elektrischen Feldlinien parallel zur Längserstreckung des Kristalls 42 bzw. parallel zum Verlauf der Lichtstrahlen verlaufen.

Auf der Hochspannungsseite ist der Kristall 42 mit einem Ringflansch 45 einer Hülse 46 fest verbunden, in der ein V-förmiges Umlenkprisma 47 untergebracht ist, mit dem ein von oben den Kristall 42 durchstrahlender Lichtstrahl wieder nach oben reflektiert wird. Die Hülse 46 ist in das Innengewinde 48 einer Haltearmatur 49 eingeschraubt, die auf der der Durchführung zugewandten Seite eine Vertiefung 50 aufweist, wodurch eine kreisringförmige Stirnfläche 51 gebildet ist, mit der die Armatur 49 auf dem Ring 32 aufliegt. Die Vertiefung 50 nimmt dann teilweise auch den Schraubenkopf der Schraube 30 auf.

Die Armatur 49 ist auf der Außenfläche teilweise von einem Rohr 52 umgeben, wobei zwischem dem Rohr 52 und der Armatur 49 eine Dichtung 53 vorgesehen ist.

Das andere Ende des Kristalls, also das in der Zeichnung Fig. 2 obere Ende und damit das niederspannungsseitige Ende ist, mit einem topfförmigen Halter 55 auf dessen Bodenaußenseite fest verbunden, der ein Außengewinde 56 aufweist, das in ein Innengewinde 57 einer weiteren Trägerarmatur 54 eingeschraubt ist. Das Rohr 52 umgibt die Außenfläche der Armatur 54 ebenfalls teilweise und unter Zwischenfügung einer Dichtung 58.

Das dem Kristall 42 abgewandte Ende der Armatur 54 ist von einer Abdeckkappe 59 teilweise umgeben, die eine zylindrische Wandung 60 aufweist, deren Außen- und Innendurchmesser dem Außen- bzw. Innendurchmesser des Rohres 52 entsprechen. Auch hier ist zwischen der Zylinderwandung 60 und der Außenfläche der Armatur 54 eine Dichtung 61 vorgesehen.

Im oben befindlichen Boden 62 der Abdeckkappe 59 befindet sich eine Öffnung 63, in der das Filter 37 eingesetzt ist. Innerhalb der Abdeckkappe 59 befinden sich optische Elemente, mit denen der Lichtstrahl dem Kristall zugeführt bzw. der reflektierte Lichtstrahl aufgefangen, d. h. empfangen wird.

Die Konturen 64 und 65 der Armaturen 49 und 54, die einander zugewandt sind, sind konvex abgerundet, so daß eine günstige Beeinflussung der dort verlaufenden Feldlinien bewirkt wird.

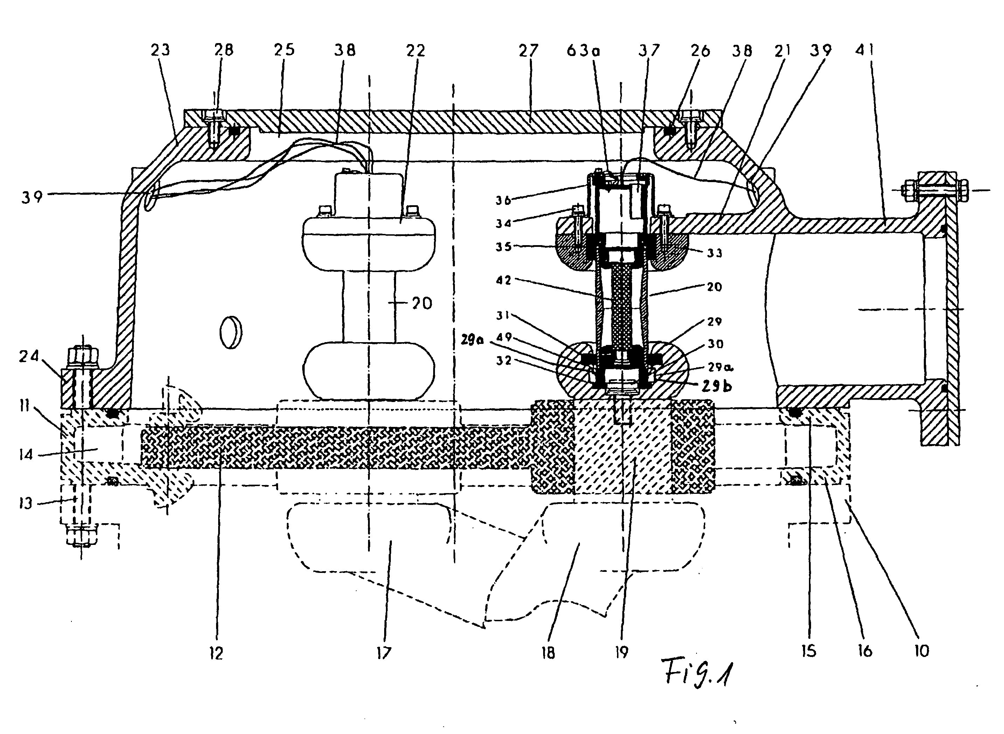

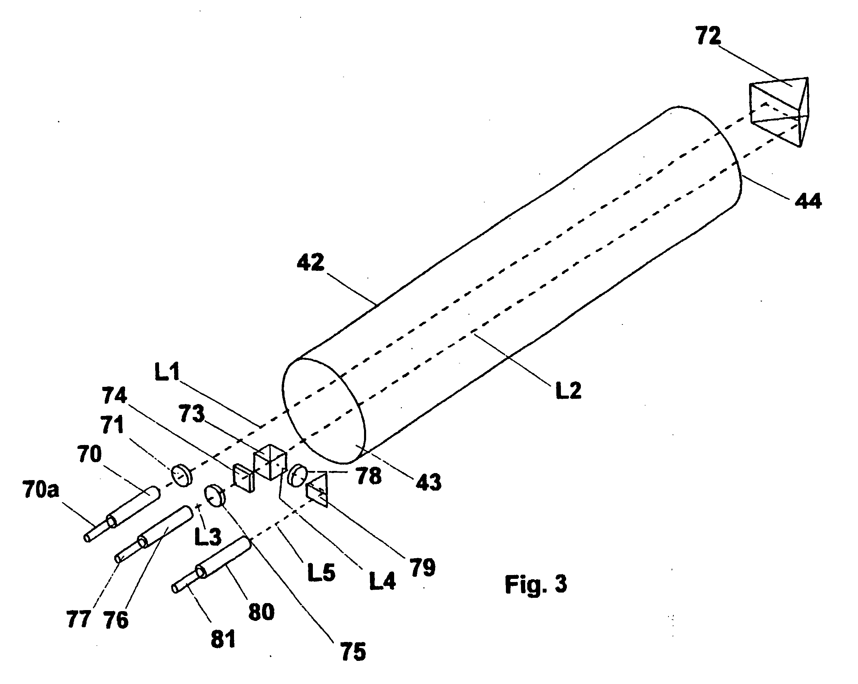

Die prinzipielle Zuordnung der optischen Elemente zu dem Kristall 42 zeigt die Fig. 3. Dem Kristall 42 und zwar auf dessen oberer (erdpotentialseitiger) transparenter und leitfähiger Fläche 43 wird über ein Linsensystem (Lichteinkoppler) 70 ein Lichtstrahl L₁ zugeführt, wobei zwischen dem Linsensystem 70 und der Fläche 43 ein erster Polarisator 71 angeordnet ist. Auf der Rückseite, d. h. der ebenfalls transparenten, leitfähigen Fläche 44 ist ein Umlenkprisma 72, das dem Umlenkprisma 47 der Fig. 2 entspricht, angeordnet, welches den Lichtstrahl L₁ umlenkt in den Lichtstrahl L₂ der dem Lichtstrahl L₁ entgegengerichtet ist. Der Lichtstrahl L₂ triftt auf einen Strahlungsteiler 73, durch den er in einen Teillichtstrahl L₃ und L₄ aufgeteilt wird, der Teillichtstrahl L₃ geht zunächst hinter dem Strahlungsteiler 73 durch eine Lamda-¼-Platte 74 und danach durch einen Analysator 75, und der Lichtstrahl L₃ wird von einem ersten optischen Linsensystem (Lichtauskoppler) 76 empfangen und über einen Lichtleiter 77 weitergegeben. Der Teilstrahl L₄ durchstrahlt zunächst einen zweiten Analysator 78, trifft dann auf ein Umlenkprisma 79 und der dadurch umgelenkte parallele Lichtstrahl L₅ wird von einem zweiten Linsensystem (Lichtauskoppler) 80 aufgenommen und über einen Lichtleiter 81 weitergeführt. Die optischen Komponenten 70, 71, 73 bis 76, 78 bis 80 befinden sich in der Abdeckkappe 59, aus der die Lichtleiter nach außen heraustreten. Der Lichtleiter, der das Licht dem Linsensystem 70 zuführt, ist mit 70a bezeichnet. In Fig. 1 ist die Kombinierung der Lichtleiter 70a, 77 und 81 insgesamt mit 38 bezeichnet.

Die einzelnen Komponenten, der Polarisator 71, das Umlenkprisma 72, der Strahlungsteiler 73 sowie die übrigen Komponenten 74, 75, 78 und 79 sind zu einer Einheit zusammengesetzt und auf der Oberfläche 43 bzw. 44 aufgeklebt.

Daß darüberhinaus auch Maßnahmen ergriffen werden, um die einzelnen Lichtstrahlen L₁, L₂, L₃, L₄ und L₅ exakt zu bündeln, ist selbstverständlich.

An der Außenfläche des Bodens 62 der Abdeckkappe 59 aus metallischem Material ist ein Leiter 63a angeschraubt bzw. elektrisch leitend befestigt, dessen anderes Ende mit der Kappe 36 elektrisch leitend verbunden ist.

Die durch die Lichtauskoppler 76, 80 empfangenen Signale werden über die Lichtleiter 38 nach außen geführt und in einer Auswerteeinrichtung (nicht gezeigt) weiterverarbeitet.

Die Erfindung kann besonders vorteilhaft bei Hochspannungsanlagen oder-schaltanlagen verwendet werden, bei denen das Spannungspotential größer als 1 KV ist.

## Patentansprüche

1. Spannungswandler mit einem in dem elektrischen Feld zwischen einem Innenleiter und einem Außenleiter einer vorzugsweise metallgekapselten, vorzugsweise gasisolierten Schaltanlage angeordneten Messelement aus einem klar transparenten Kristallmaterial, welches unter Einfluss des elektrischen Feldes durchgestrahltes polarisiertes Licht aufgrund des Pockelseffektes beeinflusst, wobei
- der Kristall (42) zwei quer zu den Feldlinien verlaufende parallele Wandungen (43, 44) aufweist,
- an der hochspannungsseitigen Wandung (44) ein erstes Umlenkprisma (72), welches einen Lichtstrahl um 180° umlenkt, und an der anderen Wandung (43), der niederspannungsseitigen Wandung, ein Lichteinkoppler (70, 71) für polarisiertes Licht und zwei Lichtauskoppler (76, 80) angeordnet sind,
- dem reflektierten Lichtstrahl (L₂) ein Strahlteiler (73) zugeordnet ist, der diesen Lichtstrahl aufteilt in zwei Teilstrahlen (L₃, L₄), von denen der eine Teitstrahl (L₃) zunächst eine Lamda-¼-Platte (74) und dann einen ersten Analysator (75) und der andere Teilstrahl (L₄) zunächst einen zweiten Analysator (78) durchstrahlt, wobei beide Teilstrahlen (L₃, L₄) je einem Lichtauskoppler (76, 80) zugeleitet sind,
**dadurch gekennzeichnet, dass**
Mittel zur Feldliniensteuerung an beiden Enden des Spannungswandlers (20) angeordnet sind, so dass im Bereich des Spannungswandlers die Feldlinien genau parallel zu den Lichtstrahlen verlaufen.

2. Spannungswandler nach Anspruch 1, **dadurch gekennzeichnet, dass** der Spannungswandler (20) zwischen einem Innenleiter (17, 18) und einem am Gehäuse (23) der Metallkapselung angebrachten Arm (21, 22) fixiert ist.

3. Spannungswandler nach einem der vorherigen Ansprüche, **dadurch gekennzeichnet, dass** als Mittel zur Feldliniensteuerung Abschirmungen (29, 33) an den Enden des Spannungswandlers (20) und je eine transparente, elektrisch leitende Schicht an den Endwänden (43, 44) des Kristalls (42) vorgesehen sind.

4. Spannungswandler nach einem der vorherigen Ansprüche, **dadurch gekennzeichnet, dass** der langgestreckte, zylinderförmige Kristall (42) in einem rohrförmigen Gehäuse (52) untergebracht ist, welches in eine Vertiefung der Abschirmungen (29, 33) eingreift und darin mittels wenigstens eines am Außenumfang des Rohres (52) angeordneten weichelastischen Ringes (31, 32; 35) elastisch gelagert ist.

5. Spannungswandler nach Anspruch 4, **dadurch gekennzeichnet, dass** der Kristall an dem hochspannungsseitigen Ende, an dem der Lichtstrahl um 180° umgelenkt wird, in eine Haltearmatur (49) eingreift, dass die Haltearmatur (49) an ihrem Außenumfang von dem Rohr (52) teilweise umfasst ist, unter Zwischenfügung eines Dichtelementes (53).

6. Spannungswandler nach einem der Ansprüche 4 oder 5, **dadurch gekennzeichnet, dass** das niederspannungsseitige Ende des Kristalls (42) in einer weiteren, rohrförmigen Trägerarmatur (54) gehalten ist, die von außen teilweise vom Rohr (52) abgedichtet umfasst ist.

7. Spannungswandler nach Anspruch 6, **dadurch gekennzeichnet, dass** die weitere Trägerarmatur (54) die optischen Komponenten wie Lichteinkoppler (70), Strahlenteiler (73), Lichtauskoppler (76, 80), Lamda-¼-Platte (74), Polarisatoren (71) und Analysatoren (75, 78) aufnimmt.

8. Spannungswandler nach Anspruch 7, **dadurch gekennzeichnet, dass** die optischen Komponenten fest mit dem Kristall (42) verbunden sind.

9. Spannungswandler nach einem der Ansprüche 6, 7 oder 8, **dadurch gekennzeichnet, dass** die weitere Trägerarmatur (54) von einer Abdeckkappe (59) umfasst ist, deren Zylinderwand die weiteren Haltearmaturen außen abdeckt.

10. Spannungswandler nach Anspruch 9, **dadurch gekennzeichnet, dass** die Abdeckkappe (59) ein Filter (37) enthält, das die Verunreinigungen des Innenraumes der Abdeckkappe (59) und des Rohres mit evtl. Zersetzungsgasen bzw. Zersetzungsprodukten des Isoliergases ausfiltert.

11. Spannungswandler nach einem der Ansprüche 9 oder 10, **dadurch gekennzeichnet, dass** die Abdeckkappe (59), die den Tragarm (21) durchgreift, auf der dem Spannungswandler (20) entgegengesetzten Seite mit einer Kappe (36) abgedeckt ist, die an dem Tragarm (21) befestigt ist.

12. Spannungswandler nach Anspruch 11, **dadurch gekennzeichnet, dass** die Abdeckkappe (59) und die Kappe (36) mittels eines elektrischen Leiters (63a) zwecks Erdung miteinander verbunden sind.

## Claims

1. A voltage converter with a measuring element which is made of a clear transparent crystalline material and is disposed in the electric field between the inner conductor and outer conductor of a preferably metal-encapsulated, preferably gas-insulated switchgear, which crystalline material, under the influence of the electric field, influences transmitted polarized light as a result of the Pockels effect, with
- the crystal (42) comprising two parallel walls (43, 44) extending transversally to the field lines;
- a first deflection prism (72) which deflects a light beam by 180° is provided at the high-voltage side wall (44) and a light input coupler (70, 71) for polarized light and two light output couplers (76, 80) are provided at the other wall, namely the low-voltage side wall;
- the reflected light beam (L₂) being associated with a beam splitter (73) which splits said light beam into two partial beams (L₃, L₄), of which the one partial beam (L₃) passes through a quarter wave plate (74) and then a first analyzer (75) and the other partial beam (L₄) passes at first through a second analyzer (78), with both partial beams (L₃, L₄) each being supplied to a light output coupler (76, 80);
**characterized in that**
means are field line control are arranged at both ends of the voltage converter (20), so that in the region of the voltage converter the field lines extend precisely parallel to the light beams.

2. A voltage converter as claimed in claim 1, **characterized in that** the voltage converter (20) is fixed between an inner conductor (17, 18) and an arm (21, 22) attached to the housing (23) of the metal encapsulation.

3. A voltage converter as claimed in one of the preceding claims, **characterized in that** screens (29, 33) are provided at the ends of the voltage converter (20) as a means for field line control and a transparent, electrically conductive layer is provided on each of the end walls (43, 44) of the crystal (42).

4. A voltage converter as claimed in one of the preceding claims, **characterized in that** the oblong, cylindrical crystal (42) is housed in a tubular housing (52) which engages in a recess of the screens (29, 33) and therein is elastically held at least one soft elastic ring (31, 32; 35) which is arranged on the outer circumference of the tube (52).

5. A voltage converter as claimed in claim 4, **characterized in that** the crystal engages in a holding bracket (49) at the high-voltage end where the light beam is deflected by 180°, that the holding bracket (49) is partly encompassed on its outer circumference by the tube (52) by interposing a sealing element (53).

6. A voltage converter as claimed in one of the claims 4 or 5, **characterized in that** the low-voltage end of the crystal (42) is held in a further tubular carrier bracket (54) which is enclosed from the outside partly by the tube (52) in a sealing manner.

7. A voltage converter as claimed in claim 6, **characterized in that** the further carrier bracket (54) receives the optical components such as the light input coupler (70), beam splitter (73), light output coupler (76, 80), quarter-wave plate (74), polarizers (71) and analyzers (75, 78).

8. A voltage converter as claimed in claim 7, **characterized in that** the optical components are rigidly connected with the crystal (42).

9. A voltage converter as claimed in one of the claims 6, 7 or 8, **characterized in that** the further carrier bracket (54) is enclosed by a covering cap (59) whose cylinder wall externally covers the further holding brackets.

10. A voltage converter as claimed in claim 9, **characterized in that** the covering cap (59) contains a filter (37) which filters out the impurities of the inner space of the covering cap (59) and the tube with possible decomposition gases or decomposition products of the insulating gas.

11. A voltage converter as claimed in one of the claims 9 or 10, **characterized in that** the covering cap (59) which grasps through the carrier arm (21) is covered by cap (36) on the side opposite of the voltage converter, which cap is fastened to the carrier arm (21).

12. A voltage converter as claimed in claim 11, **characterized in that** the covering cap (59) and the cap (36) are connected with each other by means of an electric conductor (63a) for the grounding purposes.

## Revendications

1. Capteur de tension comportant un élément de mesure formé d'un cristal clair transparent, qui est disposé dans le champ électrique entre un conducteur interne et un conducteur externe d'une installation de distribution sous enveloppe métallique, de préférence à isolation gazeuse, et qui sous l'influence du champ électrique agit par effet de Pockel sur de la lumière polarisée, dans lequel
le cristal (42) présente deux parois (43, 44) parallèles qui s'étendent transversalement aux lignes de champ
sur la paroi (44) côté haute tension est disposé un premier prisme de déviation (72), qui dévie un rayon lumineux de 180°, et sur l'autre paroi (43), paroi côté basse tension, sont disposés un coupleur de lumière (70, 71) pour la lumière polarisée et deux découpleurs de lumière (76, 80),
au rayon lumineux (L₂) réfléchi est associée une lame séparatrice (73), qui sépare le rayon lumineux en deux rayons partiels (L₃, L₄), parmi lesquels l'un (L₃) traverse d'abord une lame quart d'onde (74), puis arrive sur un premier analyseur (75), et l'autre (L₄) arrive sur un deuxième analyseur (78), les deux rayons partiels (L₃, L₄) étant envoyés chacun à un découpleur (76, 80)
**caractérisé en ce que**
des moyens de contrôle des lignes de champ sont disposés aux extrémités du capteur de tension (20), de telle sorte que dans la zone du capteur de tension, les lignes de champ soient parfaitement parallèles aux rayons lumineux.

2. Capteur de tension selon la revendication 1, **caractérisé en ce que** le capteur de tension (20) est fixé entre un conducteur interne (17, 18) et un bras (21, 22) monté sur le boîtier (23) d'enveloppe métallique.

3. Capteur de tension selon une des revendications précédentes, **caractérisé en ce qu'**il est prévu comme moyens de contrôle des lignes de champ des blindages (29, 33) placés aux extrémités du capteur de tension (20) et une couche électro-conductrice transparente appliquée sur chacune des parois d'extrémité (43, 44) du cristal (42).

4. Capteur de tension selon une des revendications précédentes, **caractérisé en ce que** le cristal (42) allongé, de forme cylindrique, est logé dans un boîtier (52) tubulaire qui pénètre dans une dépression des blindages (29, 33) et est monté élastiquement dans celles-ci par des anneaux (31, 32 ; 35) élastiques souples disposés sur la paroi extérieure du tube (52).

5. Capteur de tension selon la revendication 4, **caractérisé en ce que** le cristal à l'extrémité côté haute tension, au niveau de laquelle le rayon lumineux est dévié de 180°, pénètre dans une armature de maintien (49), **en ce que** l'armature de maintien (49) est partiellement entourée par le tube (52), un élément d' étanchéité (53) étant inséré entre deux.

6. Capteur de tension selon une des revendications 4 ou 5, **caractérisé en ce que** l'extrémité côté basse tension du cristal (42) est tenue dans une armature support (54) tubulaire supplémentaire, qui est partiellement entourée extérieurement, de manière étanche, par le tube (52).

7. Capteur de tension selon la revendication 6, **caractérisé en ce que** l'armature support (54) supplémentaire reçoit les composants optiques tels que coupleur de lumière (70), lame séparatrice (73), découpleurs de lumière (76, 80), lame quart d'onde (74), polariseurs (71) et analyseurs (75, 78).

8. Capteur de tension selon la revendication7, **caractérisé en ce que** les composants optiques sont solidaires du cristal (42).

9. Capteur de tension selon une des revendications 6, 7 ou 8 **caractérisé en ce que** l'armature support (54) supplémentaire est entourée d'une coiffe (59), dont la paroi cylindrique couvre extérieurement les armatures de maintien supplémentaires.

10. Capteur de tension selon la revendication 9, **caractérisé en ce que** la coiffe (59) contient un filtre (37), qui filtre les impuretés dans l'espace intérieur de la coiffe (59) et du tube avec éventuellement des gaz de décomposition ou des produits de décomposition du gaz isolant.

11. Capteur de tension selon une des revendications 9 ou 10, **caractérisé en ce que** la coiffe (59) qui s'étend à travers le bras support (21), du côté opposé au capteur de tension (20), est couverte par un capot (36) fixé au bras support (21).

12. Capteur de tension selon la revendication 11, **caractérisé en ce que** la coiffe (59) et le capot (36) sont reliés entre eux par un conducteur électrique (63a) à des fins de mise à la masse.
